# EUROPEAN PATENT APPLICATION

(11) **EP 4 601 174 A1**
(43) Date of publication of application: **13.08.2025**
(21) Application number: 24865930.2
(22) Date of filing: 14.08.2024
(51) Int. Cl.: H02M 1/14, H02M 1/44, H02M 3/335, H05K 1/11, H02J 7/00

(54) **POWER SUPPLY DEVICE, METHOD FOR FORMING FILTER DEVICE, AND BATTERY SYSTEM INCLUDING POWER SUPPLY DEVICE**

(30) Priority: 11.09.2023 KR 20230120505
(71) Applicant: LG Energy Solution, Ltd., Seoul 07335 (KR)
(72) Inventor: KIM, Byeong Geon, Daejeon 34122 (KR)
(74) Representative: Plasseraud IP
(86) International application number: PCT/KR2024/096012
(87) International publication number: WO 2025/058491

(57) **Abstract**

A power supply device includes: a primary-side printed circuit board (PCB); a secondary-side PCB insulated from the primary-side PCB; a filter device including a plurality of metal plates disposed between the primary-side PCB and the secondary-side PCB; and a transformer disposed on the filter device, and including a primary-side winding connected to the primary-side PCB and a secondary-side winding connected to the secondary-side PCB.

## Description

### [Technical Field]

### CROSS-REFERENCE TO RELATED APPLICATION

This application claims priority to and the benefit of Korean Patent Application No. 10-2023-0120505 filed in the Korean Intellectual Property Office on September 11, 2023, the entire contents of which are incorporated herein by reference.

The present disclosure relates to a power supply device, a method for forming a filter device, and a battery system including the power supply device.

### [Background Art]

A battery management system (BMS) that manages an operation of a battery pack may be connected to each of a low voltage region and a high voltage region. For example, the BMS may be connected to a 12 V auxiliary power (the low voltage region) of a vehicle to which the battery pack is applied and receive power required for its operation from the 12 V auxiliary power, and may be connected to the high voltage region of the battery pack and perform an operation such as a voltage measurement of the battery pack or an insulation measurement of the battery pack. A high potential difference occurring between the low voltage region and the high voltage region requires insulation, and the BMS may thus include an insulated switching mode power supply (SMPS), for example, a flyback converter.

However, electromagnetic compatibility (EMC) noise may frequently occur during an operation of the flyback converter.

### [Disclosure]

### [Technical Problem]

The present disclosure attempts to provide a power supply device that may reduce electromagnetic compatibility (EMC) noise, a method for forming a filter device, and a battery system including the power supply device.

### [Technical Solution]

According to an aspect, provided is a power supply device including: a primary-side printed circuit board (PCB); a secondary-side PCB insulated from the primary-side PCB; a filter device including a plurality of metal plates disposed between the primary-side PCB and the secondary-side PCB; and a transformer disposed on the filter device, and including a primary-side winding connected to the primary-side PCB and a secondary-side winding connected to the secondary-side PCB.

The filter device may further include a PCB, and a plurality of insulating layers of the PCB may be disposed between the plurality of metal plates. A capacitance may be provided by the plurality of metal plates and the plurality of insulating layers disposed between the plurality of metal plates.

The plurality of metal plates may be formed by filling a plurality of via holes, which extend from one surface of the filter device, with metal.

The primary-side PCB, the filter device, and the secondary-side PCB may be implemented as one PCB.

The plurality of metal plates may be arranged at regular intervals.

The plurality of metal plates may include a plurality of first metal plates connected to the primary-side PCB, and a plurality of second metal plates connected to the secondary-side PCB. The plurality of first metal plates and the plurality of second metal plates may be arranged alternately. An insulation region may be disposed between the plurality of first metal plates and the plurality of second metal plates.

According to another aspect, provided is a method for forming a filter device disposed between a primary-side printed circuit board (PCB) and a secondary-side PCB, the method including: forming a plurality of via holes in one surface of the PCB in a direction perpendicular to the one surface; and forming a plurality of metal plates by filling the plurality of via holes with metal. A plurality of insulating layers of the PCB may be disposed between the plurality of metal plates.

A transformer may be disposed to face one surface of the filter device.

According to still another aspect, provided is a battery system including: a battery pack including a plurality of battery cells; a battery management system monitoring the battery pack and controlling charging and discharging of the battery pack; and a power supply device supplying power to the battery management system. The power supply device may include a primary-side printed circuit board (PCB); a secondary-side PCB insulated from the primary-side PCB; a filter device including a plurality of metal plates disposed between the primary-side PCB and the secondary-side PCB; and a transformer disposed on the filter device, and including a primary-side winding connected to the primary-side PCB and a secondary-side winding connected to the secondary-side PCB.

The filter device may further include the PCB, and a plurality of insulating layers of the PCB are disposed between the plurality of metal plates. A capacitance may be provided by the plurality of metal plates and the plurality of insulating layers disposed between the plurality of metal plates.

### [Advantageous Effects]

As set forth above, the present disclosure provides the power supply device that may reduce the electromagnetic compatibility (EMC) noise, the method for forming a filter device, and the battery system including the power supply device.

### [Description of the Drawings]

FIG. 1 is a block diagram showing a power supply device according to an embodiment.
FIG. 2 is a circuit diagram of the power supply device.
FIG. 3 is a diagram showing a conventional primary-side printed circuit board (PCB) and a conventional secondary-side PCB.
FIG. 4 is a simulation graph showing a capacitance between the conventional primary-side PCB and secondary-side PCB.
FIG. 5 is a diagram showing a primary-side PCB, a filter device, and a secondary-side PCB according to an embodiment.
FIG. 6 is a simulation graph showing a capacitance between the primary-side PCB and the secondary-side PCB according to an embodiment.
FIG. 7 is a diagram showing a primary-side PCB, a filter device, and a secondary-side PCB according to another embodiment.
FIG. 8 is a simulation graph showing a capacitance between the primary-side PCB and the secondary-side PCB according to an embodiment.
FIG. 9 is a diagram showing a primary-side PCB, a filter device, and a secondary-side PCB according to still another embodiment.
FIG. 10 is a simulation graph showing a capacitance between the primary-side PCB and the secondary-side PCB according to an embodiment.
FIG. 11 is a schematic diagram showing a filter device according to an embodiment.
FIGS. 12 and 13 are diagrams each showing a method for forming a plurality of metal plates according to an embodiment.
FIG. 14 is a diagram showing a battery system including a power supply device according to an embodiment.

### [Mode for Invention]

In describing embodiments disclosed in the specification, omitted is a detailed description of a case where it is decided that the detailed description of the known art related to the present disclosure may obscure the gist of the present disclosure. In addition, it is to be understood that the accompanying drawings are provided only to allow the embodiments of the present disclosure to be easily understood, and the spirit of the present disclosure is not limited by the accompanying drawings and includes all the modifications, equivalents, and substitutions included in the spirit and scope of the present disclosure.

Terms including ordinal numbers such as "first" and "second" may be used to describe various components. However, these components are not limited to these terms. These terms are used only to distinguish one component and another component from each other.

It is to be understood that when one component is referred to as being "connected to" or "coupled to" another component, one component may be directly connected or coupled to another component, or may be connected or coupled to another component while having a third component interposed therebetween. On the other hand, it is to be understood that when one component is referred to as being "directly connected to" or "directly coupled to" another component, one component may be connected or coupled to another component without a third component interposed therebetween.

It is to be further understood that the terms such as "include" and "have", used in the specification specify the presence of features, numerals, steps, operations, components, parts, or combinations thereof, mentioned in the specification, and do not preclude the presence or addition of one or more other features, numerals, steps, operations, components, parts, or combinations thereof.

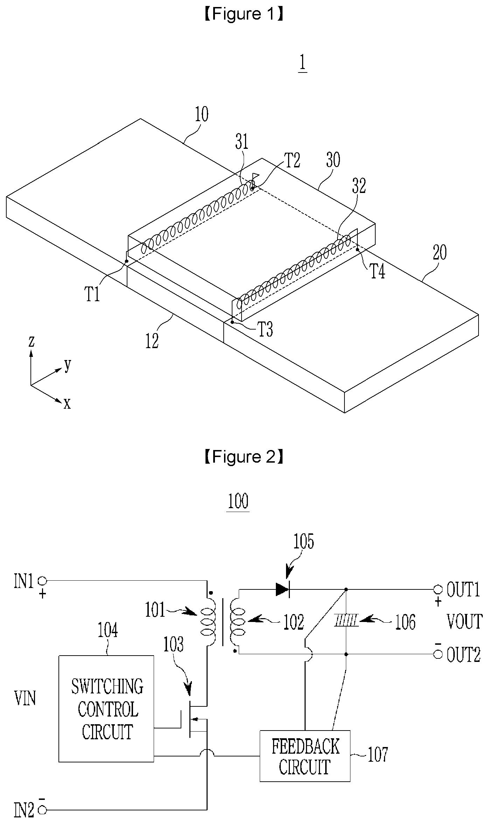

FIG. 1 is a block diagram showing a power supply device according to an embodiment.

As shown in FIG. 1, a power supply device 1 may include a primary-side printed circuit board (PCB) 10, a secondary-side PCB 20, a transformer 30, and a filter device 12. The primary-side PCB 10, the filter device 12, and the secondary-side PCB 20 may be implemented as one PCB, or may be implemented as separate PCBs and connected to each other. The primary-side PCB 10 and secondary-side PCB 20 may be implemented as at least two PCB layers.

The transformer 30 may include a primary-side winding 31 and a secondary-side winding 32. In the transformer 30, the primary-side winding 31 and the secondary-side winding 32 may be electrically insulated from each other. To describe an electrical connection between the transformer 30 and the primary-side PCB 10, and between the transformer 30 and the secondary-side PCB 20, FIG. 1 also schematically shows each region of the primary-side winding 31 and the secondary-side winding 32 that is disposed in the transformer 30. The primary-side winding 31 and the secondary-side winding 32 may be actually implemented in various ways other than those shown in FIG. 1.

The primary-side PCB 10 may include two connection terminals T1 and T2 electrically connected to one end and the other end of the primary-side winding 31. The two connection terminals T1 and T2 may be electrically connected to other components through two corresponding via holes in the primary-side PCB 10. The primary-side PCB 10 may include two input terminals connected to a low-voltage power supply. For example, two output terminals of a 12 V auxiliary power supply disposed in a vehicle may be electrically connected to the two input terminals.

The secondary-side PCB 20 may include two connection terminals T3 and T4 electrically connected to one end and the other end of the secondary-side winding 32. The two connection terminals T3 and T4 may be electrically connected to other components through two corresponding via holes in the secondary-side PCB 20. The secondary-side PCB 20 may supply a voltage to another circuit operated in a high voltage region. For example, a voltage required for the battery management system to measure a voltage of a battery pack may be supplied to the battery management system through the secondary-side PCB 20. A voltage required for the battery management system to measure an insulation resistance of the battery pack may be supplied to the battery management system through the secondary-side PCB 20.

The filter device 12 may be disposed between the primary-side PCB 10 and the secondary-side PCB 20 in a first direction (x axis direction in FIG. 1), and may be disposed in a second direction (-z axis direction in FIG. 1) with respect to the transformer 30. The filter device 12 may include a plurality of metal plates formed in a yz direction and arranged between the primary-side PCB 10 and the secondary-side PCB 20 in the first direction. The filter device 12 and the transformer 30 may be electrically insulated by an insulator, or may be electrically insulated from each other by being spatially separated from each other. As shown in FIG. 1, the transformer 30 may be disposed to face an upper surface of the filter device 12.

FIG. 1 shows that the filter device 12 and the primary-side PCB 10 are in contact with each other. However, the filter device 12 and the primary-side PCB 10 may be insulated from each other because the filter device 12 may include an insulating material at a surface where the filter device 12 and the primary-side PCB 10 are in contact with each other. Similarly, FIG. 1 shows that the filter device 12 and the secondary-side PCB 20 are in contact with each other. However, the filter device 12 and the secondary-side PCB 20 may be insulated from each other because the filter device 12 may include the insulating material at a surface where the filter device 12 and the secondary-side PCB 20 are in contact with each other.

FIG. 2 is a circuit diagram of the power supply device.

The power supply device shown in FIG. 2 may be implemented as a flyback converter applicable to an embodiment.

A power supply device 100 may include a primary-side winding 101, a secondary-side winding 102, a switching circuit 103, a switching control circuit 104, a rectifier diode 105, an output capacitor 106, and a feedback circuit 107.

One end of the primary-side winding 101 may be connected to an input terminal IN1, and the other end of the primary-side winding 102 may be connected to one end of the switching circuit 103. The switching circuit 103 may include a plurality of power transistors. The plurality of power transistors may be n-channel type transistors, and may be connected in parallel with each other. The other end of the primary-side winding 102 may be connected to a drain of the switching circuit 103. The other end of the switching circuit 103 may be connected to an input terminal IN2. Input power may be connected between the two input terminals IN1 and IN2. For example, the 12 V auxiliary battery of the vehicle may have a positive pole connected to the input terminal IN1 and a negative pole connected to the input terminal IN2.

The secondary-side winding 102 may have one end connected to an anode of the rectifier diode 105 and the other end connected to a secondary-side output terminal OUT2. A cathode of the rectifier diode 105 may be connected to a secondary-side output terminal OUT1, and the output capacitor 106 may be connected between the secondary-side output terminal OUT1 and the secondary-side output terminal OUT2 to filter a ripple of an output voltage VOUT and smooth the output voltage VOUT.

The feedback circuit 107 may generate a feedback voltage VF based on the output voltage VOUT and provide the same to the switching control circuit 104. The feedback circuit 107 may include an insulating coupler, for example, an optocoupler, which is electrically connected to each of the insulated primary-side and secondary-side.

The switching control circuit 104 may generate a gate signal VG that controls an on-duty ratio of the switching circuit 103 based on the feedback voltage VF. The switching circuit 103 may be turned on when the gate signal VG is at an on level, and turned off when the gate signal VG is at an off level. The switching control circuit 104 may increase an on-duty ratio of the gate signal VG when the feedback voltage VF is increased due to decrease in the output voltage VOUT as a load is increased. Power provided from a primary side to a secondary side may then be increased. Conversely, the switching control circuit 104 may decrease the on-duty ratio of the gate signal VG when the feedback voltage VF is decreased due to increase in the output voltage VOUT as the load is decreased. Power provided from the primary side to the secondary side may then be decreased. In this way, the switching control circuit 104 may regulate the output voltage VOUT.

A primary-side configuration of the primary-side winding 101, the switching circuit 103, the switching control circuit 104, and the feedback circuit 107, disposed in the primary side of the power supply device 100 shown in FIG. 2 may be implemented in the primary-side PCB 10 shown in FIG. 1. A secondary-side configuration of the secondary-side winding 101, the rectifier diode 105, the output capacitor 106, and the feedback circuit 107, disposed in the secondary side of the power supply device 100 shown in FIG. 2 may be implemented in the secondary-side PCB 20 shown in FIG. 1.

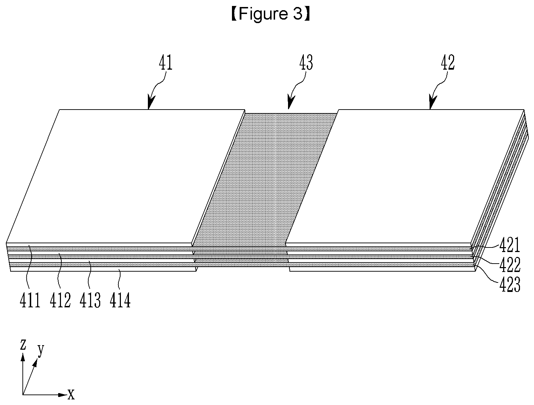

FIG. 3 is a diagram showing a conventional primary-side printed circuit board (PCB) and a conventional secondary-side PCB.

As shown in FIG. 3, a primary-side PCB 41 and a secondary-side PCB 42 include four metal layers 411 to 414 and three FR4 layers 421 to 423 disposed between the two metal layers. An insulation region 43 only including the FR4 layers 421 to 423 may be disposed between the primary-side PCB 41 and the secondary-side PCB 42.

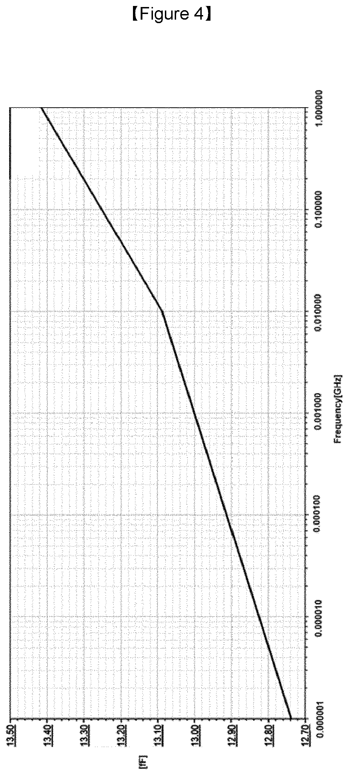

FIG. 4 is a simulation graph showing a capacitance between the conventional primary-side PCB and secondary-side PCB.

In the graph shown in FIG. 4, a horizontal axis indicates a signal frequency generated between the primary-side PCB 41 and the secondary-side PCB 42, and a vertical axis indicates the capacitance between the primary-side PCB and the secondary-side PCB, and its unit is "femto farad (fF)". As shown in FIG. 4, in a frequency range of 100 KHz to 1 GHz, the capacitance between the primary-side PCB and the secondary-side PCB may be 12.74 to 13.40 [fF].

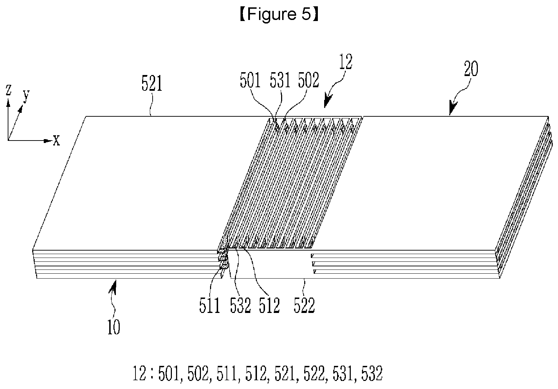

FIG. 5 is a diagram showing a primary-side PCB, a filter device, and a secondary-side PCB according to an embodiment.

FIG. 5 shows a connection relationship between the primary-side PCB 10 and the filter device 12, a connection relationship between the secondary-side PCB 20 and the filter device 12, and a configuration of the filter device 12.

The filter device 12 may include a plurality of metal plates 501, 502, 511, and 512, two connecting electrodes 521 and 522, and a plurality of insulating layers 531 and 532.

The primary-side PCB 10 and the secondary-side PCB 20 may include four metal layers and a layer of FR4 disposed between the two adjacent metal layers. The primary-side PCB 10 may be electrically connected to the filter device 12 via the connecting electrode 521. For example, a ground of the primary-side PCB 10 may be connected to the connecting electrode 521. The secondary-side PCB 20 may be electrically connected to the filter device 12 via the connecting electrode 522. For example, a ground of the secondary-side PCB 20 may be connected to the connecting electrode 522.

The plurality of metal plates 501, 502, 511, and 512 may be formed in a plurality of via holes formed in an insulation region 43 shown in FIG. 3. The plurality of metal plates 501, 502, 511, and 512 may extend along an yz plane and be arranged along an x axis. The plurality of metal plates 501, 502, 511, and 512 may have some (for example, 501 and 502) connected to the connecting electrode 521, and the others (for example, 511 and 512) connected to the connecting electrode 522. The plurality of metal plates connected to the connecting electrode 521 and the plurality of metal plates connected to the connecting electrode 522 may be disposed alternately, and the insulating layer may be disposed between the adjacent metal plates. For example, the plurality of metal plates 501, 511, 502, and 512 may be sequentially disposed, and the insulating layer (for example, 531 or 532) may be disposed between the two adjacent metal plates (for example, 501 and 511 or 511 and 502). In this way, the capacitance may be formed between the primary-side PCB 10 and the secondary-side PCB 20.

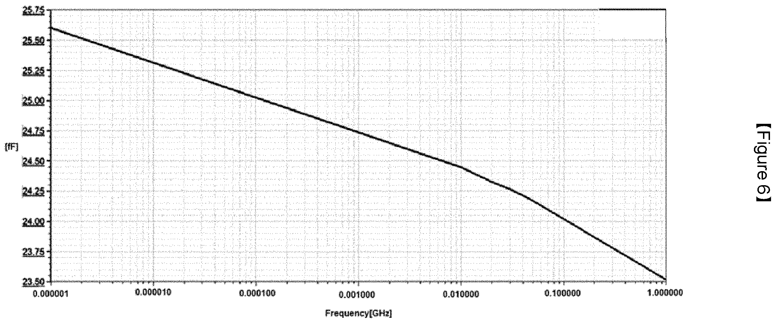

FIG. 6 is a simulation graph showing the capacitance between the primary-side PCB and the secondary-side PCB according to an embodiment.

In the graph shown in FIG. 6, a horizontal axis indicates a signal frequency generated between the primary-side PCB 10 and the secondary-side PCB 20, and a vertical axis indicates a capacitance between the primary-side PCB 10 and the secondary-side PCB 20, and its unit is "pico farad (pF)". As shown in FIG. 6, in the frequency range of 100 KHz to 1 GHz, the capacitance between the primary-side PCB and the secondary-side PCB may be 23.50 to 25.54 [pF]. FIG. 6 shows that the capacitance greater than the conventional capacitance shown in FIG. 4 by 2000 times or more may be provided.

The shape and configuration of the filter device are not limited to the preceding embodiment, and may be variously modified.

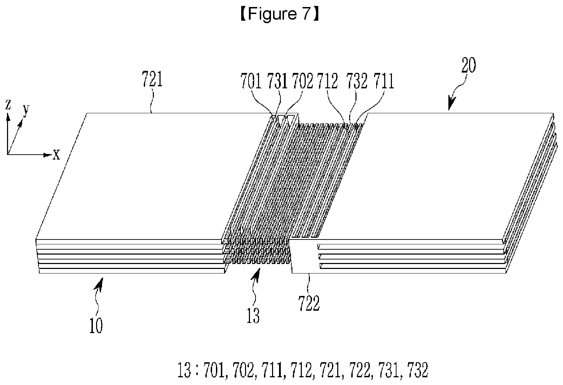

FIG. 7 is a diagram showing a primary-side PCB, a filter device, and a secondary-side PCB according to another embodiment.

FIG. 7 shows a connection relationship between the primary-side PCB 10 and a filter device 13, a connection relationship between the secondary-side PCB 20 and the filter device 13, and a configuration of the filter device 13. The embodiment shown in FIG. 7 shows the filter device 13 including a smaller number of metal plates compared to the filter device 12 shown in FIG. 5.

The filter device 13 may include a plurality of metal plates 701, 702, 711, and 712, two connecting electrodes 721 and 722, and a plurality of insulating layers 731 and 732.

The primary-side PCB 10 and the secondary-side PCB 20 may include four metal layers and an FR4 layer disposed between the two adjacent metal layers. The primary-side PCB 10 may be electrically connected to the filter device 13 via the connecting electrode 721. For example, the ground of the primary-side PCB 10 may be connected to the connecting electrode 721. The secondary-side PCB 20 may be electrically connected to the filter device 13 via the connecting electrode 722. For example, the ground of the secondary-side PCB 20 may be connected to the connecting electrode 722.

The plurality of metal plates 701, 702, 711, and 712 may be formed in the plurality of via holes formed in the insulation region 43 shown in FIG. 3. The plurality of metal plates 701, 702, 711, and 712 may extend along the yz plane and be arranged along the x axis. The plurality of metal plates 701, 702, 711, and 712 may have some (for example, 701 and 702) connected to the connecting electrode 721, and the others (for example, 711 and 712) connected to the connecting electrode 522. The insulating layer (for example, 731 or 732) may be disposed between the two adjacent metal plates (for example, 701 and 702 or 711 and 712). In this way, the capacitance may be formed between the primary-side PCB 10 and the secondary-side PCB 20.

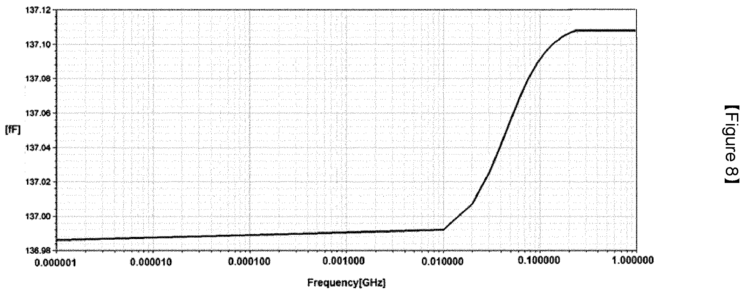

FIG. 8 is a simulation graph showing the capacitance between the primary-side PCB and the secondary-side PCB according to an embodiment.

In the graph shown in FIG. 8, a horizontal axis indicates a signal frequency generated between the primary-side PCB 10 and the secondary-side PCB 20, and a vertical axis indicates a capacitance between the primary-side PCB 10 and the secondary-side PCB 20, and its unit is "femto farad (fF)". As shown in FIG. 8, in the frequency range of 100 KHz to 1 GHz, the capacitance between the primary-side PCB and the secondary-side PCB may be 136.98 to 137.11 [fF]. FIG. 8 shows that the capacitance greater than the conventional capacitance shown in FIG. 4 by 10 times or more may be provided.

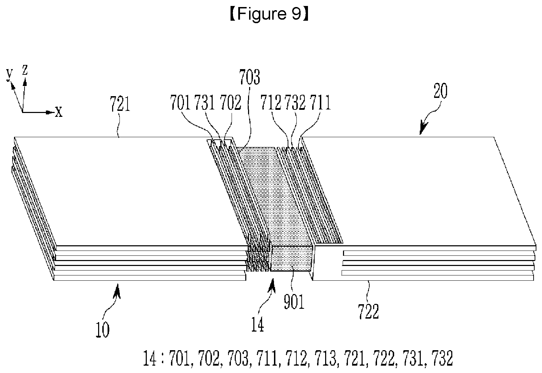

FIG. 9 is a diagram showing a primary-side PCB, a filter device, and a secondary-side PCB according to still another embodiment.

FIG. 9 shows a connection relationship between the primary-side PCB 10 and a filter device 14, a connection relationship between the secondary-side PCB 20 and the filter device 14, and a configuration of the filter device 14. The filter device 14 shown in FIG. 9 has an insulating layer whose shape is different from that in the filter device 13 shown in FIG. 5. In FIG. 9, the same configuration may be denoted with the same drawing reference numerals as in FIG. 7, and its description is omitted below.

The filter device 14 may include the plurality of metal plates 701, 702, 711, and 712, the two connecting electrodes 721 and 722, and a plurality of insulating layers 731, 732, and 901. The insulating layer 901 may also be made of FR4.

The insulating layer 901 may be implemented as one layer disposed between the metal plate 703 disposed to be farthest from the primary-side PCB 10 among the plurality of metal plates 701 to 703 connected to the connecting electrode 721 and the metal plate 713 disposed to be farthest from the secondary-side PCB 20 among the plurality of metal plates 711 to 713 connected to the connecting electrode 722. In this way, the capacitance may be formed between the primary-side PCB 10 and the secondary-side PCB 20.

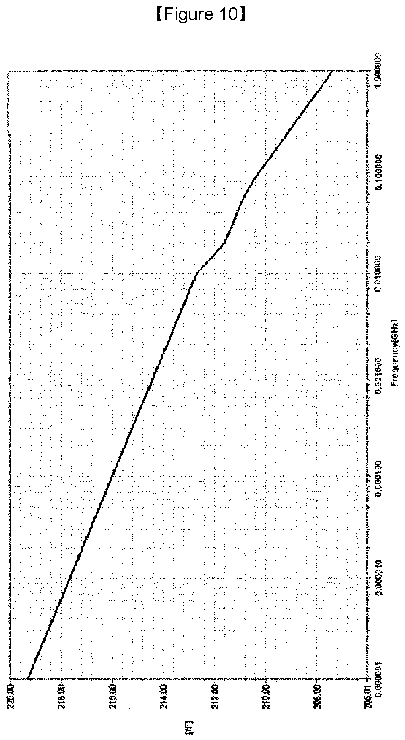

FIG. 10 is a simulation graph showing the capacitance between the primary-side PCB and the secondary-side PCB according to an embodiment.

In the graph shown in FIG. 10, a horizontal axis indicates a signal frequency generated between the primary-side PCB 10 and the secondary-side PCB 20, and a vertical axis indicates a capacitance between the primary-side PCB 10 and the secondary-side PCB 20, and its unit is "femto farad (fF)". As shown in FIG. 10, in the frequency range of 100 KHz to 1 GHz, the capacitance between the primary-side PCB and the secondary-side PCB may be 207 to 219 [fF]. FIG. 10 shows that the capacitance greater than the conventional capacitance shown in FIG. 4 by 15 times or more may be provided.

In this way, the filter device 12, 13, or 14 may filter the EMC noise occurring in the power supply device by providing the capacitance between the primary side and secondary side of the transformer 30. The filter device 12, 13, or 14 may be disposed between the primary-side PCB 10 and the secondary-side PCB 20 while being insulated, and thus filter the EMC noise while maintaining the insulation between the low voltage region and high voltage region of the power supply device.

Hereinafter, the description describes a method of forming the metal plate in the filter device.

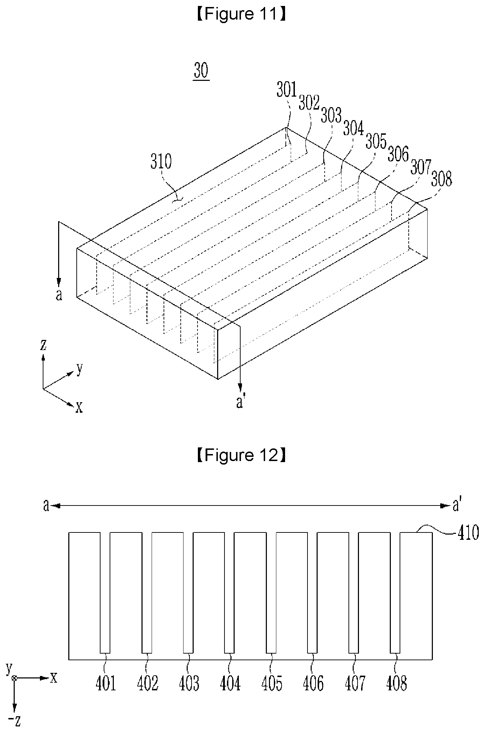

FIG. 11 is a schematic diagram showing a filter device according to an embodiment.

For convenience of description, a plurality of metal plates 301 to 308 formed in the filter device 12 may be shown transparently in FIG. 11. The filter device 12 may include the plurality of metal plates 301 to 308. As shown in FIG. 11, each of the plurality of metal plates 301 to 308 may be formed to extend in the yz plane direction. FIG. 11 shows that the plurality of metal plates 301 to 308 are eight plates, and the present disclosure is not limited thereto. In the filter device 12, a portion other than the plurality of metal plates 301 to 308 may be implemented as the insulating material. For example, the filter device 12 may include the plurality of metal plates 301 to 308 arranged at regular intervals in the PCB. Accordingly, in the filter device 12, the portion other than the plurality of metal plates 301 to 308 may be made of the insulating material. That is, the insulating layer may be disposed between the two adjacent metal plates among the plurality of metal plates 301 to 308. In detail, the PCB may be implemented as FR4 which is a glass fiber reinforced epoxy laminate sheet.

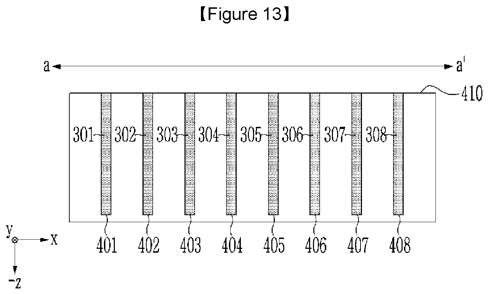

FIGS. 12 and 13 are diagrams each showing a method for forming a plurality of metal plates according to an embodiment.

FIGS. 12 and 13 show cross-sectional views taken along line a-a' of FIG. 12 during a process of forming the plurality of metal plates 301 to 308.

As shown in FIG. 12, a plurality of via holes 401 to 408, in which the plurality of metal plates 301 to 308 are to be formed, may be formed by drilling or laser from an upper surface 410 (corresponding to an upper surface 310 in FIG. 11) of the FR4 PCB in a vertical direction (-z-axis direction). The plurality of via holes 401 to 408 may be formed in the yz direction, and arranged at regular intervals in the first direction (x-axis direction).

As shown in FIG. 13, the plurality of via holes 401 to 408 may each be filled with metal by via fill technology. The plurality of metal plates 301 to 308 may then be formed in the plurality of via holes 401 to 408.

FIGS. 12 and 13 are examples of the method for forming the plurality of metal plates 301 to 308, and the present disclosure is not limited thereto. There may be various ways to provide a space such as the plurality of via holes in the PCB where the plurality of metal plates may be disposed. In addition, there may be various ways to fill the space with metal.

As shown in FIG. 11, the insulating layers may be disposed between the plurality of metal plates 301 to 308 and the plurality of metal plates 301 to 308, and the filter device 12 may thus provide a predetermined capacitance. For example, the capacitance may be formed between the two adjacent metal plates among the plurality of metal plates 301 to 308. As a result, the plurality of capacitances may be formed between the plurality of metal plates 301 to 308, and an overall capacitance synthesized from the plurality of capacitances may be provided.

The filter devices 13 and 14 of the embodiments in FIGS. 7 and 9 may be implemented using the method shown in FIGS. 12 and 13.

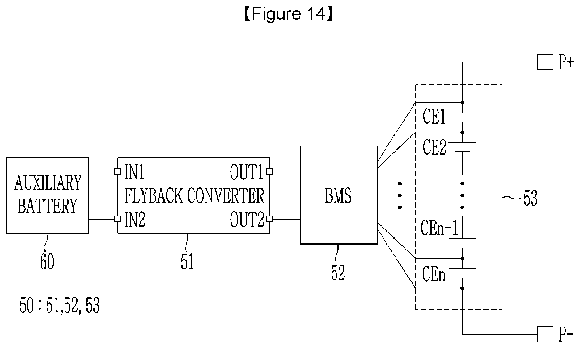

FIG. 14 is a diagram showing a battery system including a power supply device according to an embodiment.

An auxiliary battery 60 may supply power of a constant voltage to a power supply device 51. Two output terminal of the auxiliary battery 60 may be connected to two input terminals IN1 and IN2 of the power supply device 51. The auxiliary battery 60 may be disposed in the vehicle mounted with a battery system 50.

The battery system 50 may include the power supply device 51, a battery management system (BMS) 52, and a battery pack 53.

The power supply device 51 may be implemented according to the embodiments described above. The power supply device 51 may convert power supplied from the auxiliary battery 60 and supply the same to the BMS 53.

The battery pack 53 may include a plurality of battery cells CE1 to CEn. FIG. 5 shows that the plurality of battery cells CE1 to CEn are connected in series between two output terminals P+ and P- of the battery pack 53. However, the plurality of battery cells CE1 to CEn may be connected in parallel and/or in series with each other.

The BMS 52 may be operated using power supplied from the power supply device 51. The BMS 52 may monitor the battery pack 53, and control charging and discharging of the battery pack 53. The BMS 52 may measure a cell voltage of each of the plurality of battery cells CE1 to CEn, measure a current flowing through the battery pack 53, and measure a temperature of the battery pack 53. The BMS 52 may control the charging and discharging of the battery pack 53 based on the measured values, and detect abnormalities to thus control a protection operation for the battery pack 53.

Although the embodiments of the present disclosure have been described in detail hereinabove, the scope of the present disclosure is not limited thereto, and may include various modifications and alterations made by those skilled in the art using a basic concept of the present disclosure as defined in the claims.

## Claims

1. A power supply device comprising:
a primary-side printed circuit board (PCB);
a secondary-side PCB insulated from the primary-side PCB;
a filter device including a plurality of metal plates disposed between the primary-side PCB and the secondary-side PCB; and
a transformer disposed on the filter device, and including a primary-side winding connected to the primary-side PCB and a secondary-side winding connected to the secondary-side PCB.

2. The device of claim 1, wherein
the filter device further includes a PCB, and a plurality of insulating layers of the PCB are disposed between the plurality of metal plates.

3. The device of claim 2, wherein
a capacitance is provided by the plurality of metal plates and the plurality of insulating layers disposed between the plurality of metal plates.

4. The device of claim 1, wherein
the plurality of metal plates are
formed by filling a plurality of via holes, which extend from one surface of the filter device, with metal.

5. The device of claim 1, wherein
the primary-side PCB, the filter device, and the secondary-side PCB are implemented as one PCB.

6. The device of claim 1, wherein
the plurality of metal plates are arranged at regular intervals.

7. The device of claim 1, wherein
the plurality of metal plates include
a plurality of first metal plates connected to the primary-side PCB, and
a plurality of second metal plates connected to the secondary-side PCB.

8. The device of claim 7, wherein
the plurality of first metal plates and the plurality of second metal plates are arranged alternately.

9. The device of claim 7, wherein
an insulation region is disposed between the plurality of first metal plates and the plurality of second metal plates.

10. A method for forming a filter device disposed between a primary-side printed circuit board (PCB) and a secondary-side PCB, the method comprising:
forming a plurality of via holes in one surface of the PCB in a direction perpendicular to the one surface; and
forming a plurality of metal plates by filling the plurality of via holes with metal,
wherein a plurality of insulating layers of the PCB are disposed between the plurality of metal plates.

11. The method of claim 10, wherein
a transformer is disposed to face one surface of the filter device.

12. A battery system comprising:
a battery pack including a plurality of battery cells;
a battery management system monitoring the battery pack and controlling charging and discharging of the battery pack; and
a power supply device supplying power to the battery management system,
wherein the power supply device includes
a primary-side printed circuit board (PCB);
a secondary-side PCB insulated from the primary-side PCB;
a filter device including a plurality of metal plates disposed between the primary-side PCB and the secondary-side PCB; and
a transformer disposed on the filter device, and including a primary-side winding connected to the primary-side PCB and a secondary-side winding connected to the secondary-side PCB.

13. The system of claim 12, wherein
the filter device further includes the PCB, and a plurality of insulating layers of the PCB are disposed between the plurality of metal plates.

14. The system of claim 13, wherein
a capacitance is provided by the plurality of metal plates and the plurality of insulating layers disposed between the plurality of metal plates.
